Europäisches Patentamt

(19) European Patent Office

Office européen des brevets

(11) Numéro de publication: **0 002 166**
A2

# (12) DEMANDE DE BREVET EUROPEEN

(21) Numéro de dépôt: 78430015.4

(22) Date de dépôt: 04.10.78

(51) Int. Cl.²: **H 01 L 23/32,** H 01 L 23/48,
H 01 L 21/96, H 05 K 1/04
// B23P1/08

---

(30) Priorité: 18.11.77 US 852779

(71) Demandeur: **International Business Machines Corporation, Armonk, N.Y. 10504 (US)**

(72) Inventeur: **Hammer, Robert, 36 Knollcrest Drive, Brookfield Center Connecticut 06805 (US)**
Inventeur: **Sachar, Kenneth Selig, 499 North Broadway, White Plains New York 10603 (US)**
Inventeur: **Sampogna, Michael, 3E Surrey Lane, Wappingers Falls New York 12590 (US)**

(43) Date de publication de la demande: 30.05.79
Bulletin 79/11

(74) Mandataire: **Gallois, Gerard, COMPAGNIE IBM FRANCE Département de Propriété Industrielle, F-06610 - La Gaude (FR)**

(84) Etats contractants désignés: **DE FR GB**

---

(54) **Support pour microplaquettes de circuits intégrés, et son procédé de fabrication.**

(57) Le support comprend une couche diélectrique (2) d'où fait saillie un réseau de broches (6) munies d'un épaulement (7), isolées électriquement entre elles, et un plan de masse (5) isolé électriquement des broches, mais composé du même matériau que celles-ci. Un revêtement isolant (8) couvre le plan (5) et entoure les broches. La fabrication est réalisée par l'électro-érosion d'un substrat du matériau des broches, adjacent à la couche (2), attachée à un support amovible (3). L'isolement électrique des broches est parachevé par une attaque chimique jusqu'à la couche (2) des restes de matériau du substrat laissé autour des broches par l'électro-érosion. Le procédé permet d'éviter tout traitement mécanique tel que l'abrasage ou polissage de la couche (2) en cas d'insertion mécanique de broches.

Peuvent être utilisés dans les dispositifs électroniques à circuits intégrés.

1

# SUPPORT POUR MICROPLAQUETTES DE CIRCUITS INTEGRES, ET SON PROCEDE DE FABRICATION

## Description

### Domaine technique de l'invention

La présente invention concerne un support sur lequel peuvent être montées des microplaquettes de circuits intégrés, et son procédé de fabrication. Plus particulièrement, la présente invention concerne un support pour microplaquettes de circuits intégrés qui comprend un plan de masse et des broches électriquement isolées, et son procédé de fabrication.

### Etat de la technique antérieure

La plupart des supports sur lesquels peuvent être montées des microplaquettes à circuits intégrés actuellement disponibles dans le commerce sont fabriqués à partir d'un matériau électriquement isolant, par exemple une feuille en céramique, dans lequel sont insérés sur un de ses côtés des broches conductrices qui vont être ensuite connectés à des cartes ou des panneaux. Les feuilles de céramique sont normalement perforées de trous et le réseau de broches requis pour une application particulière est ensuite inséré dans la céramique par les trous déjà perforés. Le processus ci-dessus souffre des difficultés rencontrées lors de l'insertion

2

des broches dans les trous, ou évidements, déjà formés.

Par ailleurs, une proposition récente consiste à utiliser un support conducteur qui joue le rôle de plan de masse et dans lequel sont insérés des broches électriquement isolées. Dans cette proposition, une mince couche isolante couvre la structure et l'isole des microplaquettes à circuits intégrés qui sont montées sur la surface de la couche isolante. Cette structure est avantageuse en ce sens qu'elle élimine le besoin de broches de retour séparées. Cependant, les inconvénients qui consistent à avoir à insérer les broches dans les trous ou évidements appropriés, sont toujours présents. En outre, pour obtenir une surface plane sur le côté opposé à celui qui contient les broches, il est nécessaire d'employer des procédés d'abrasage et de polissage. Ces procédés sont utilisés une fois les broches insérées et une fois la structure revêtue d'une couche isolante et, par voie de conséquence, soulèvent certains problèmes relatifs à la performance. Par exemple, l'abrasage et le polissage deviennent difficiles lorsqu'une surface est composée de zones réalisées dans des matériaux différents, par exemple, des zones réalisées dans un matériau conducteur et d'autres réalisées dans un matériau isolant, vu que ces matériaux sont polis à des cadences différentes.

Bien que le brevet des E.U.A. No. 3 991 347 évoque un dispositif dans lequel des régions conductrices sont électriquement isolées du reste du matériau, le procédé utilisé pour arriver à cette fin n'y est pas décrit explicitement.

Le brevet des E.U.A No. 3 455 239 suggère la formation de tiges. Ce brevet suggère d'utiliser des faisceaux

3

d'électrons pour fabriquer les tiges. Mais il ne suggère pas la présence d'une couche d'isolement électrique pas plus qu'il ne suggère l'isolement des tiges.

Le brevet des E.U.A No. 3 881 244 suggère la formation de plusieurs plots espacés dans une pastille de silicium semi-conducteur à l'aide de procédés de masquage et d'attaque sélectifs.

On peut également citer, comme art antérieur, les brevets des E.U.A. No. 3 387 952 et No. 3 851 382 qui suggèrent des moyens employés comme élément d'arrêt durant la formation d'une configuration.

Exposé de l'invention

La présente invention concerne un support pour microplaquettes à circuits intégrés qui comprend un élément diélectrique, ou couche isolante, contenant un réseau de broches électriquement conductrices espacées qui font saillie sur un de ses côtés, support dans lequel les broches sont électriquement isolées entre elles. Le support comprend également un plan de masse conducteur ou semi-conducteur qui couvre substantiellement tout le côté du matériau diélectrique d'où font saillie les broches sauf qu'il est également électriquement isolé de chacune des broches. Une encapsulation non conductrice et/ou un agent de remplissage couvre le plan de masse et entoure chaque broche dans le réseau de broches. Des connexions électriques peuvent traverser le matériau diélectrique. Le support peut être monté, par exemple, dans une carte ou un panneau de circuits intégrés au moyen de techniques bien connues, par exemple, par enfichage, soudage ou câblage.

4

La caractéristique de fabrication de la présente invention est d'obtenir un substrat électriquement conducteur ou semi-conducteur qui est revêtu d'un côté d'un film diélectrique. Un élément support est rattaché à l'autre côté du film diélectrique. L'élément support est temporairement rattaché (par exemple, de façon amovible) au film diélectrique. Il est produit un réseau de broches en soumettant le substrat électriquement conducteur ou semi-conducteur à un procédé d'électro-érosion (ou étincelage). Les broches sont électriquement isolées entre elles en enlevant le matériau du substrat qui, après le procédé de fabrication par électro-érosion, reste autour de chacune des broches du réseau jusqu'à la couche diélectrique.

Un agent d'encapsulation et/ou un matériau de remplissage est appliqué pour recouvrir le plan de masse et pour entourer chacune des broches du réseau; après quoi, l'élément support est supprimé. L'élément support est employé à la fois pour supporter l'objet alors soumis à l'électro-érosion et pour protéger la surface du film diélectrique de manière à maintenir sa planéiité. Etant donné que la planéiité du film isolant est maintenue durant la fabrication, il n'est pas nécessaire de traiter mécaniquement sa surface pour obtenir une surface plane.

Par voie de conséquence, la présente invention permet d'éliminer les procédés mécaniques de traitement de surface nécessaires dans l'art antérieur pour obtenir une surface plane. En outre, la présente invention élimine le besoin d'insérer des broches conductrices rapportées dans un support, comme cela était le cas dans l'art antérieur.

5

D'autres objets, caractéristiques et avantages de la présente invention ressortiront mieux de l'exposé qui suit, fait en référence aux dessins annexés à ce texte, qui représentent un mode de réalisation préféré de celle-ci.

## Description des figures

Les figures 1 à 6 représentent des schémas du support durant différentes étapes du procédé conforme à la présente invention.

La figure 7 représente schématiquement un appareil à électro-érosion qui peut être utilisé pour mettre en oeuvre le procédé de la présente invention.

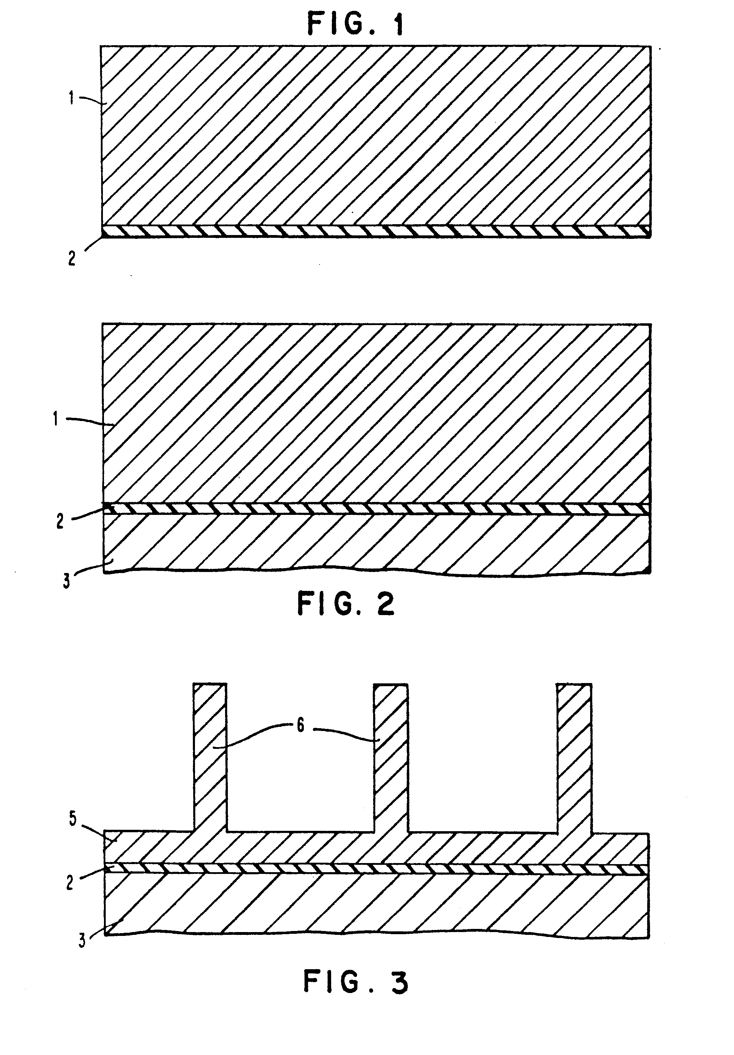

La figure 1 représente un article comprenant un substrat conducteur ou semi-conducteur 1 sur l'un des côtés duquel est déposé un film diélectrique 2. Les surfaces du substrat sont de préférence planes et lisses. Le substrat conducteur ou semi-conducteur peut être réalisé dans un matériau quelconque qui est électriquement conducteur et qui convient à la fabrication du réseau de broches. Ces matériaux appropriés comprennent les métaux électriquement conducteurs ainsi que les matériaux non métalliques qui, néanmoins, peuvent posséder des caractéristiques semi-conductrices, par exemple, le silicium dopé, le polysilicium dopé, l'arseniure de gallium dopé, ou le germanium dopé. Comme exemples de quelques métaux appropriés, on peut citer le molybdène, le tungstène, le cuivre, les carbures métalliques, le laiton, l'acier, et divers métaux non ferreux tels que l'aluminium. Le substrat conducteur ou semi-conducteur doit, bien entendu, pouvoir être traité par un procédé

6

d'électro-érosion. La sélection de matériaux appropriés peut être facilement réalisée par l'homme de l'art après qu'il aura pris connaissance de la présente invention. L'épaisseur du substrat est principalement déterminée par la longueur requise des broches à fabriquer et, de façon générale est de l'ordre d'environ 0,25mm à environ 2,5cm et, de préférence, cette longueur se situe entre environ 2,5mm et environ 5mm.

La couche diélectrique peut être un matériau électriquement isolant quelconque et dépend principalement des conditions électriques demandées finalement au support. Par exemple, le matériau diélectrique peut être l'un quelconque des matériaux isolants bien connus comprenant des polymères synthétiques tels que les polyimides, et des verres englobant les bioxydes de silicium, les verres au phosphore et le quartz obtenu par pulvérisation réactive. La couche diélectrique peut être formée en tant que surface plane sur un substrat conducteur lisse et, puisque cette surface est protégée, comme cela sera décrit par la suite, au cours des étapes de traitement, la surface va rester complètement plane et ne va nécessiter aucun autre traitement mécanique pour la rendre plane. La couche diélectrique est relativement mince en comparaison du substrat et a habituellement une épaisseur de l'ordre d'environ 1 à environ 10 microns.

La couche diélectrique sert, d'un côté, de support à la microplaquette et, de l'autre, de moyen de maintien des broches. Un type de film diélectrique qui peut être utilisé conformément à la présente invention est un verre de Schott déposé à l'aide d'un faisceau d'électrons sur une épaisseur d'environ 6 microns.

7

Lorsque le substrat est du silicium dopé ou du polysilicium dopé, la couche isolante ou diélectrique peut être formée en oxydant un côté du substrat de silicium ou de polysilicium suivant l'épaisseur requise au moyen d'une technique d'oxydation classique pour obtenir l'oxyde de silicium. Par exemple, l'oxydation peut se faire par des techniques d'oxydation thermique. En outre, si besoin est, l'oxyde peut être déposé par des techniques bien connues de dépôt sous vide ou par vapeur chimique. Le substrat de silicium ou de polysilicium est dopé avec des impuretés du type conforme à la conductivité requise. Par exemple, le dopage de type p peut se faire avec des matériaux tels que le bore, l'aluminium, le gallium et l'indium. Le dopage de type n se fait avec de l'arsenic, du phosphore, et de l'antimoine. Des techniques de dopage classiques sont l'implantation ionique et la diffusion thermique. Ces techniques sont bien connues dans l'art antérieur et ne seront pas décrites plus avant.

Un élément support amovible 3 (voir figure 2), par exemple une plaque de verre ou une plaque de métal, par exemple une plaque de cuivre, ou une plaque de résine, par exemple un polyimide, est rattaché à un côté du film diélectrique (c'est-à-dire, au côté du film diélectrique qui n'est pas adjacent au substrat). Il est souhaitable d'employer une plaque de verre transparente qui laisse voir la couche diélectrique. La plaque de résine peut être formée dans un matériau qui est photosensible et qui peut cuire lorsqu'il est exposé à une énergie ondulatoire appropriée pour devenir insoluble dans les solvants qui vont être utilisés dans la suite du procédé.

8

La plaque support est suffisamment épaisse pour que l'article puisse être maintenu dans la machine utilisée pour l'électro-érosion. Habituellement, l'épaisseur adéquate est de l'ordre d'environ 0,3 à environ 0,6 centimètres. L'élément support amovible peut être rattaché au film diélectrique en utilisant une cire de liaison éliminable ou un adhésif (non représenté) à l'interface de l'élément support 3 et du film diélectrique 2. L'élément support est présent pour maintenir temporairement en place le réseau de broches après leur fabrication. Les adhésifs couramment utilisés comme spécimens temporaires ou comme adhésifs de montage peuvent être utilisés dans la présente invention. Un type particulier d'adhésif disponible dans le commerce est connu sous le nom de "De Khotinsky" dont certains sont à base d'un mélange de gomme shellac et de goudron de pin. D'autres adhésifs appropriés sont le phthalate de glycol et de nombreuses compositions adhésives à base de cire. L'adhésif temporaire doit être suffisamment fort pour maintenir l'élément support durant tout le procédé de fabrication tout en étant cependant facilement éliminable, par exemple par, immersion dans un bain de solvant qui n'affecte pas les autres matériaux de l'ensemble (par exemple, la couche isolante et les broches).

L'article est ensuite soumis à une technique d'électro-érosion (EDM) de manière à obtenir le réseau de broches requis. Tout le réseau peut être fabriqué simultanément par opposition aux techniques classiques dans lesquelles les broches sont séparément insérées dans le support. Les techniques EDM sont bien connues et les paramètres particuliers impliqués pour la réalisation pratique du procédé de la présente invention peuvent facilement

9

être déterminés par l'homme de l'art après étude de la présente invention. Plus particulièrement, les techniques d'électro-érosion dépendent fondamentalement du matériau du substrat, du matériau de l'outil et de la tension employés. Pour plus de précision concernant la technique EDM, on peut se reporter à l'ouvrage intitulé "Metals Handbook" Vol. 3, ASM, Electrical Discharge Machining (EDM), John F. Kahles, pages 227 et suivantes et Machine Tools, Chapitre 24, Electrical Machining, pages 401 à 411. On peut également se reporter au brevet des E.U.A. No. 3 671 706 qui s'appuie sur l'utilisation de la technique EDM pour fabriquer des tiges de saisie qui coopèrent avec un doigt de saisie pour enserrer une feuille. Il est à noter que ce brevet n'a rien à voir avec la présente invention puisque, entre autres, le matériau diélectrique lisse n'y est pas mentionné. De plus, l'isolement électrique des tiges de saisie n'est pas mentionné et n'a aucune raison d'être.

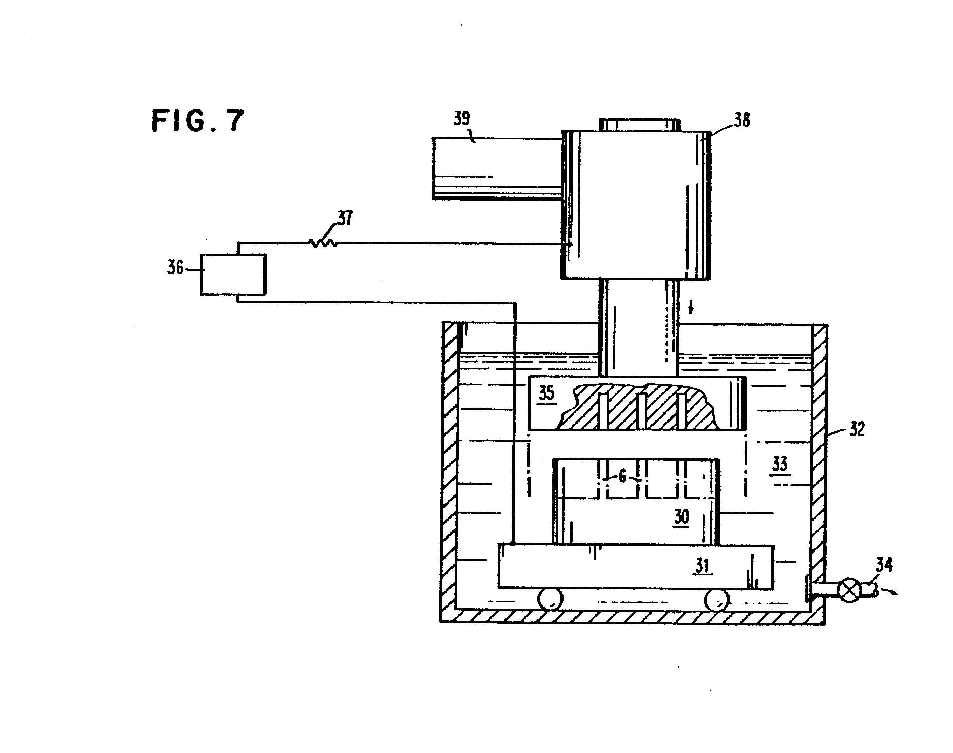

La figure 7 représente schématiquement une machine appliquant le principe d'électro-érosion qui peut être utilisée pour la réalisation de la présente invention. La technique d'électro-érosion est basée sur un procédé dans lequel on donne forme à un matériau électriquement conducteur par suppression contrôlée du matériau à l'aide d'un procédé de vaporisation ou de fusion induit par des étincelles électriques à haute fréquence. Les étincelles déchargées sont produites par une impulsion contrôlée de courant continu entre l'article alors traité (qui est habituellement anodique ou chargé positivement) et l'outil ou l'électrode qui est habituellement la cathode ou l'électrode négative. La forme des broches est obtenue en utilisant une électrode qui

10

a la forme complémentaire en creux de la forme des broches requise.

L'extrémité de l'électrode et l'article alors traité sont séparés par un entrefer d'où vont jaillir les étincelles, entrefer dont la dimension est de l'ordre d'environ 0,0012cm à environ 0,05 centimètre, et sont immergés ou inondés dans un fluide diélectrique. Le matériau diélectrique présent dans l'entrefer est partiellement ionisé sous l'application d'impulsions de tension élevée ce qui permet alors la décharge des étincelles entre l'outil et l'article alors traité. Chaque étincelle produit suffisamment de chaleur pour faire fondre ou vaporiser une faible quantité de l'article sous traitement, ce qui a pour résultat de laisser apparaître une petite cavité, ou cratère, dans la surface de l'article.

En référence à la figure 7, l'article à façonner 30 est fixé sur une table de travail 31 à l'aide de moyens de verrouillage (non représentés). La table de travail est placée dans un réservoir 32 qui contient un fluide diélectrique 33. Le fluide diélectrique sert de conducteur d'étincelles, de matière de réfrigération et de moyens de balayage des petites particules de matériau enlevées de l'article alors traité, par le drain 34.

Le fluide doit avoir une constante diélectrique convenable et doit pouvoir se ioniser facilement à la tension appliquée qui, par exemple, est de l'ordre d'environ 40 à environ 400 volts, afin de conduire la décharge d'étincelles. En outre, le fluide doit pouvoir refroidir le métal fondu ou vaporisé produit par l'étincelle et l'enlever de l'entrefer. Le fluide est conti-

11

nuellement filtré et peut être recyclé, ou bien un nouveau fluide peut être utilisé. Des exemples de fluides diélectriques convenables sont l'huile d'hydrocarbure (pétrole) ayant une viscosité de l'ordre d'environ 4,3 centi-stockes à 37,7°C (4,3 $10^{-6}$ $m^2$ $s^{-1}$), le kérosène, les huiles silicones, l'eau désionisée, les solutions aqueuses d'étylène glycol. Le fluide doit ne pas pouvoir dissoudre l'adhésif temporaire qui est utilisé pour faire adhérer l'élément support à la couche diélectrique.

L'outil, est placé face à l'article à traiter et est une image complémentaire en creux du réseau de broche requis. La figure 7 représente l'outil avant sa mise en place pour la fabrication des broches. Comme le montre cette figure, des charges électriques opposées sont induites entre l'outil et l'article alors traité. Suivant la figure, l'article traité est positivement chargé et l'outil est négativement chargé à partir d'une source continue 36. La quantité d'énergie est contrôlée par la résistance variable 37.

La figure 7 représente une façon de maintenir l'entrefer approprié séparant l'outil et l'article en cours de traitement. Dans ce mode de réalisation, un moteur asservi 39 commande le déplacement du dispositif de soutien d'outil 38 de manière à maintenir constant l'entrefer où jaillissent les étincelles. Le moteur asservi obtient un signal d'entrée provenant de la différence existant entre une tension de référence sélectionnée et la tension véritable présente dans l'entrefer. Le signal est amplifié et l'outil avance par commande hydraulique. Un court-circuit dans l'entrefer inverse le déplacement de l'outil par le moteur asservi.

12

Si besoin est, les broches peuvent être fabriquées par électro-érosion afin de former un épaulement 7 autour de chaque broche. L'épaulement est utilisé pour augmenter la solidité globale des broches. Cet épaulement peut être obtenu en concevant l'outil de sorte qu'il soit une image complémentaire en creux de la broche avec l'épaulement, tel que représenté sur le dessin, ou bien en utilisant deux étapes séparées d'électro-érosion, la première étape employant un outil dont la forme est l'image de la broche sans épaulement, comme le montre la figure 3, la seconde étape employant un outil qui est l'image de l'épaulement 7 de la broche. Les dimensions relatives de la broche et de l'épaulement sont fonction de la densité de broches désirée par le futur utilisateur de l'article. On a pu fabriquer des broches ayant un diamètre de l'ordre de 0,25mm avec des épaulements ayant un diamètre de 0,375mm, ces broches étant espacées centre-à-centre sur une distance de 1,25mm. De façon générale, il est souhaitable d'avoir des broches ayant un diamètre d'au moins environ 0,05mm. En outre, lorsque la dimension requise des broches est suffisamment grande, par exemple, lorsque cette dimension correspond à un diamètre de l'ordre de 0,375mm, il n'est pas nécessaire que les broches aient un épaulement.

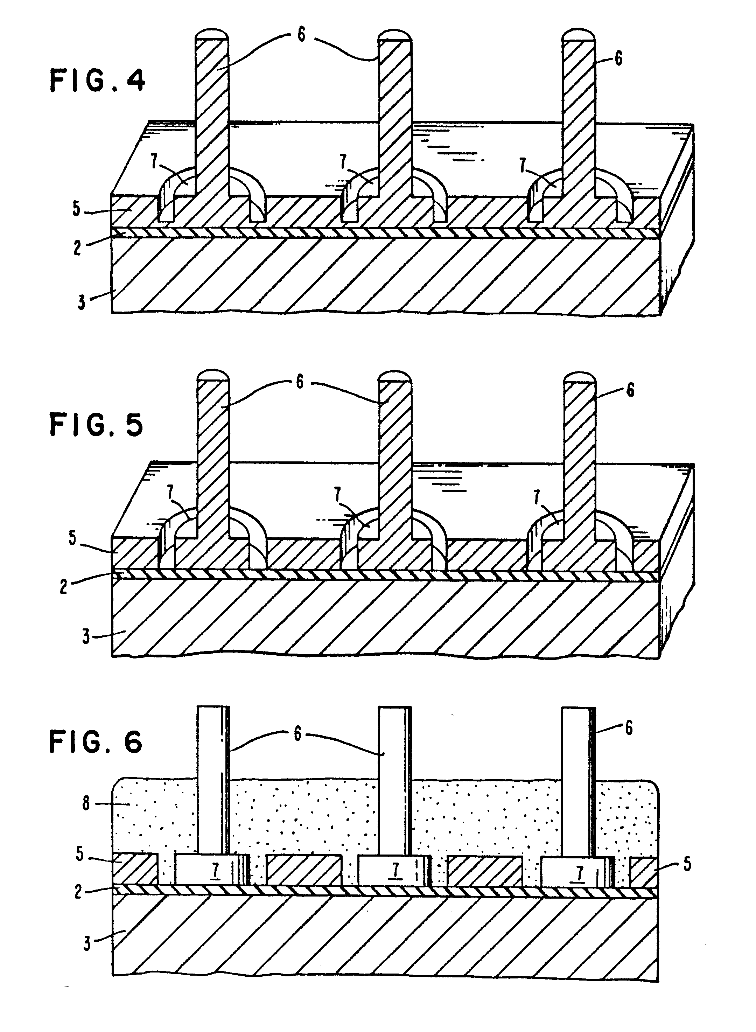

Comme le montre la figure 4, les broches, après le traitement complet par électro-érosion, ne sont toujours pas isolées électriquement entre-elles étant donné qu'il reste autour de chacune des broches une épaisseur relativement faible de matériau semi-conducteur ou conducteur dans lequel est fait le substrat. l'électro-érosion est réalisée de manière à venir aussi près que possible de la couche diélectrique 3 sans affecter la couche isolante. Vu que le procédé peut être commandé

13

avec précision, il est possible d'électro-éroder la base
de la broche à 0,025mm, voire moins, de l'interface
séparant le substrat et la couche isolante. D'autres
techniques de fabrication ne maîtrisent pas suffisamment la commande pour satisfaire ces strictes tolérances.
Par exemple, une fabrication électrochimique ne peut
pas être suffisamment contrôlée pour être envisagée
dans la présente invention.

Le matériau conducteur restant autour des diverses broches peut maintenant être supprimé, par exemple, par un
procédé d'attaque chimique. Etant donné que seule une
faible épaisseur du matériau doit être supprimée au
cours de cette étape pour isoler électriquement les broches, l'étape d'attaque n'a qu'un effet négligeable sur
la forme et la dimension de la broche. Une attaque
prolongée modifierait de façon importante la taille des
broches. L'agent d'attaque sélectionné est un agent qui
ne va pas modifier le matériau diélectrique une fois le
substrat traversé. La figure 5 montre les broches comme
étant complètement isolées.

Un exemple de matériau d'attaque approprié pouvant être
employé est de l'acide nitrique dilué (par exemple dans
une solution aqueuse à 50%). L'attaque peut se faire en
plaçant l'article dans un récipient (par exemple un
becher) contenant l'acide nitrique dilué, et, ensuite,
en plaçant ce récipient dans un bain d'eau qui est
agité par ultrasons. En général, le substrat peut être
attaqué sur une épaisseur d'environ 0,025 à 0,050mm
pendant un temps d'environ 15 secondes à environ 1
minute.

L'épaisseur finale du substrat 5, après traitement, est

14

normalement de l'ordre de 0,5 à 1mm.

Les broches, maintenant électriquement isolées, sont complètement fixées en place en appliquant un agent de revêtement non conducteur 8 qui recouvre le plan de masse 5 et qui recouvre partiellement les broches 6 tout en remplissant l'espace qui les sépare. Des exemples de quelques uns des agents de remplissage et de revêtement appropriés sont les compositions du type à encapsulation telles que les compositions de polymère saturés ou non saturés comme, par exemple, les matériaux époxy, les polyimides et les gommes synthétiques y compris celles qui ont été employées préalablement pour sceller et encapsuler partiellement les broches dans un substrat porteur. La résine époxy peut être, par exemple, un polymère bis-phénol A - épi-chlorohydrine et peut être combinée à un agent de cuisson à la température ambiante. Les liants peuvent être soumis à cuisson de manière à lier de façon permanente les broches pendant la durée de leur utilisation.

Une fois les broches liées de façon permanente, l'élément support 3 peut être supprimé. Par exemple, pour les adhésifs temporaires décrits ci-dessus, des solvants tels que des alcools, de l'acétone, ou du trichloréthylène, peuvent être utilisés pour détruire le liant de l'élément support et de la couche isolante sans affecter la planéité de la couche isolante. Cette opération se fait par immersion de l'article dans le solvant. Le trichloréthylène est utilisé avec un adhésif à base de cire connu sous le terme "cire noire"; l'opération est suivie par un rinçage avec de l'acétone.

L'article peut être connecté au circuit désiré par des

15

connexions électriques appropriées au travers du matériau diélectrique. L'article peut être monté, par exemple, sur des cartes ou des panneaux de circuits intégrés et peut être connecté par une technique quelconque bien connue, par exemple, par câblage, enfichage, ou bien cet article peut être soudé.

Comme le mettent en évidence les étapes décrites ci- dessus, la présente invention fournit un procédé pour obtenir des broches électriquement isolées, distinctes dans un plan de masse ainsi qu'une couche d'isolement plane qui ne nécessite pas d'étapes mécaniques supplémentaires, par exemple, des étapes d'abrasage et de polissage, pour être plane. La présente invention offre un procédé qui peut être facilement automatisé ce qui fait que les dimensions peuvent être contrôlées de façon rigoureuse et précise. Vu la précision de la commande et la rigueur des tolérances obtenues à l'aide de la présente invention, on peut préparer des supports pour microplaquettes à densité élevée.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

1

REVENDICATIONS

1.  Support pour microplaquette de circuits intégrés
comportant:

un élément diélectrique,

un réseau de broches espacées, électriquement
conductrices ou semi-conductrices, mais électriquement isolées les unes des autres, placées d'un
côté de cet élément diélectrique,

un plan de masse conducteur ou semi-conducteur
couvrant la face de cet élément diélectrique
placée du même côté de celui-ci que les broches,
ce plan de masse étant isolé de chacune de ces
broches,

caractérisé en ce que:

les broches font saillie de cette face de l'élément diélectrique,

le plan de masse est constitué du même matériau
que les broches.

2. Support pour microplaquette de circuits intégrés selon la revendication 1 caractérisé en ce que:

ces broches comprennent un épaulement situé contre l'élément diélectrique.

3. Support pour microplaquette de circuits intégrés selon la revendication 1 ou 2 caractérisé en ce que:

un agent de revêtement et de remplissage non conducteur couvre ce plan de masse et entoure le réseau de broches.

4. Support pour microplaquette de circuits intégrés selon l'une des revendications 1 à 3 caractérisé en ce que:

des connexions électriques traversent l'élément diélectrique.

5. Procédé pour fabriquer un support pour microplaquette de circuits intégrés, caractérisé en ce qu'il comprend les étapes suivantes:

a. obtention d'un substrat électriquement conducteur ou semi-conducteur sur l'un des côtés duquel est déposée une couche diélectrique,

b. attachement, de façon amovible, de la face de la couche diélectrique, non adjacente au substrat, à un élément support,

3

c. traitement par électro-érosion du substrat de façon à produire un réseau de broches faisant saillie du substrat,

d. décapage chimique du matériau du substrat situé autour de chaque broche jusqu'à la surface de la couche diélectrique pour assurer l'isolation électrique des broches les unes avec les autres et avec le reste du substrat,

e. détachement de l'élément support.

6. Procédé pour fabriquer un support pour microplaquette de circuits intégrés selon la revendication 5 caractérisé en ce que:

l'élément support est attaché de façon amovible à la couche diélectrique en utilisant un adhésif temporaire.

7. Procédé pour fabriquer un support pour microplaquette de circuits intégrés selon la revendication 6 caractérisé en ce que:

l'élément support est détaché en plongeant l'ensemble élément support et couche diélectrique dans un bain solvant qui dissout l'adhésif temporaire.

8. Procédé pour fabriquer un support pour microplaquette de circuits intégrés selon l'une quelconque des revendications 5 à 7 caractérisé en ce que le traitement par électro-érosion se fait en deux étapes, la première étape produisant le corps

4

principal des broches et la seconde étape produisant un épaulement sur les broches adjacent à la couche diélectrique.

9. Procédé pour fabriquer un support pour microplaquette de circuits intégrés selon l'une quelconque des revendications 5 à 8 caractérisé en ce que:

le traitement par électro-érosion du substrat est conduit jusqu'à une distance de l'ordre de 0,025mm de la couche diélectrique.

10. Procédé pour fabriquer un support pour microplaquette de circuits intégrés selon l'une quelconque des revendications 5 à 9 caractérisé en ce qu'il comprend l'étape supplémentaire de:

f. application d'un agent non conducteur de revêtement et de remplissage pour recouvrir le substrat et pour entourer chacune des broches du réseau de broches.

# FIG. 1

# FIG. 2

# FIG. 3

FIG.4

FIG.5

FIG.6

FIG. 7